# EUROPEAN PATENT APPLICATION

(11) **EP 4 776 009 A1**
(43) Date of publication of application: **15.07.2026**
(21) Application number: 25867153.6
(22) Date of filing: 07.08.2025
(51) Int. Cl.: G01R 31/3835, G01R 31/367, G01R 31/36, G01R 31/392, G01R 31/396, H02J 7/00

(54) **BATTERY MANAGEMENT APPARATUS AND BATTERY MANAGEMENT METHOD**

(30) Priority: 08.10.2024 KR 20240136530
(71) Applicant: LG ENERGY SOLUTION, LTD., Seoul 07335 (KR)
(72) Inventor: CHOI, Hyun Jun, Daejeon 34122 (KR); KIM, Tae Hyeon, Daejeon 34122 (KR)
(74) Representative: Goddar, Heinz J.
(86) International application number: PCT/KR2025/011884
(87) International publication number: WO 2026/079620

(57) **Abstract**

According to an embodiment disclosed in this document, there is provided a battery management device including an interface configured to acquire a voltage profile representing a voltage relative to a capacity of a battery cell and at least one processor, in which the at least one processor is configured to identify at least one inflection point based on the voltage profile, identify a capacity of silicon contained in the battery cell using the at least one inflection point, and control charging or discharging of the battery cell based on the capacity of silicon.

## Description

### TECHNICAL FIELD

### Cross-reference to Related Applications

This application claims priority from Korean Patent Application No. 10-2024-0136530, filed on October 8, 2024, the disclosure of which is incorporated by reference herein.

### Technical Field

Embodiments disclosed in this document relate to a battery management device and a battery management method.

### BACKGROUND ART

Non-destructive differential analysis technology is one of the methods for evaluating battery performance and battery state, and may refer to a technology that checks a physical or chemical state inside the battery. Non-destructive differential analysis technology may be used for battery life prediction or performance improvement research because it allows the internal state of a battery to be checked without damaging the battery. Non-destructive differential analysis technology may be used to check performance degradation, and/or lithium ion migration due to changes in active materials, side reactions thereof, etc. in the battery, by measuring changes in the battery due to electrochemical properties during the charging and discharging process The capacity profile (or voltage profile) acquired by non-destructive differential analysis technology may include data representing the characteristics of each material within the battery. Therefore, a method may be required to quantify material-specific degradation by utilizing the unique characteristics inherent to each material within the battery.

### DISCLOSURE OF THE INVENTION

### TECHNICAL PROBLEM

Embodiments disclosed in this document provide a battery management device and a battery management method for diagnosing a battery cell by identifying a degree of degradation of each material within the battery cell.

The technical problems of the embodiments disclosed in the document are not limited to the technical problems mentioned above, and other technical problems not mentioned will be clearly understood by those skilled in the art from the descriptions below.

### TECHNICAL SOLUTION

According to an embodiment disclosed in this document, there is provided a battery management device including an interface configured to acquire a voltage profile representing a voltage relative to a capacity of a battery cell and at least one processor, in which the at least one processor is configured to identify at least one inflection point based on the voltage profile, identify a capacity of silicon contained in the battery cell using the at least one inflection point, and control charging or discharging of the battery cell based on the capacity of silicon.

For example, the at least one processor may be configured to acquire a second-order differential voltage profile acquired through second differentiation of the voltage profile, and identify the at least one inflection point in the second-order differential voltage profile.

For example, the at least one processor may be configured to identify the capacity of silicon using a first capacity value of the battery cell corresponding to the at least one inflection point and a second capacity value corresponding to an end point of the second-order differential voltage profile.

For example, the at least one processor may be configured to identify a total capacity profile representing the capacity of the battery cell according to the use of the battery cell, identify a silicon capacity profile representing the capacity of silicon according to the use of the battery cell, and control charging or discharging of the battery cell according to the total capacity profile and the silicon capacity profile.

For example, the at least one processor may be configured to identify a total capacity value of the total capacity profile at a designated point in time, identify the silicon capacity value of the silicon capacity profile at the designated point in time, and control charging or discharging of the battery cell when a ratio of the silicon capacity value to the total capacity value is less than or equal to a designated ratio.

For example, the at least one processor may be configured to set a designated voltage of the battery cell and control charging or discharging of the battery cell based on the designated voltage.

For example, the at least one processor may be configured to reduce an upper limit charging voltage when the designated voltage is the upper limit charging voltage.

For example, the at least one processor may be configured to increase a lower limit discharging voltage when the designated voltage is the lower limit discharging voltage.

According to an embodiment disclosed in this document, there is provided a simulation method including an operation of identifying at least one inflection point based on a voltage profile representing a voltage relative to a capacity of a battery cell, an operation of identifying a capacity of silicon contained in the battery cell using the at least one inflection point, and an operation of controlling charging or discharging of the battery cell based on the capacity of silicon.

For example, the operation of identifying the at least one inflection point may include an operation of acquiring a second-order differential voltage profile acquired through second differentiation of the voltage profile and an operation of identifying the at least one inflection point in the second-order differential voltage profile.

For example, the operation of identifying the capacity of silicon may include an operation of identifying the capacity of silicon using a first capacity value of the battery cell corresponding to the at least one inflection point and a second capacity value corresponding to an end point of the second-order differential voltage profile.

For example, the operation of controlling the charging of the battery cell may include an operation of identifying a total capacity profile representing the capacity of the battery cell according to the use of the battery cell, an operation of identifying a silicon capacity profile representing the capacity of silicon according to the use of the battery cell, and an operation of controlling charging or discharging of the battery cell according to the total capacity profile and the silicon capacity profile.

For example, the operation of controlling the charging of the battery cell may include an operation of identifying a total capacity value of the total capacity profile at a designated point in time, an operation of identifying the silicon capacity value of the silicon capacity profile at the designated point in time, and an operation of controlling charging or discharging of the battery cell when a ratio of the silicon capacity value to the total capacity value is less than or equal to a designated ratio.

For example, the operation of controlling the charging of the battery cell may include may include an operation of setting a designated voltage of the battery cell and an operation of controlling charging or discharging of the battery cell based on the designated voltage.

For example, the operation of controlling the charging of the battery cell may further include an operation of reducing an upper limit charging voltage when the designated voltage is the upper limit charging voltage.

### ADVANTAGEOUS EFFECTS

The battery management device and battery management method according to the embodiments disclosed in this document can diagnose a battery cell by identifying a degree of degradation of each material within the battery cell.

In addition, various effects that are directly or indirectly identified through this document can be provided.

### BRIEF DESCRIPTION OF THE DRAWINGS

FIG. 1 is a block diagram illustrating the configuration of a battery management device according to an embodiment disclosed in this document.
FIG. 2 illustrates an example of a graph representing a voltage profile acquired by a battery management device according to an embodiment disclosed in this document.
FIG. 3 illustrates an example of a graph corresponding to a type of electrode included in a battery cell according to an embodiment disclosed in this document.
FIG. 4 illustrates an example of a graph showing a degree of degradation of a capacity of silicon according to an embodiment disclosed in this document.
FIG. 5 illustrates an example of a graph showing a ratio of a capacity of silicon according to an embodiment disclosed in this document.
FIG. 6 illustrates an example of an exemplary flowchart illustrating an operation of a battery management device according to an embodiment disclosed in this document.
FIG. 7 illustrates a computing system executing a battery management method according to an embodiment disclosed in this document.

### MODE FOR CARRYING OUT THE INVENTION

Hereinafter, some embodiments described in this document are described with reference to the accompanying drawings. However, this is not intended to limit the present technology to a specific embodiment, but should be understood to include various modifications, equivalents, and/or alternatives of the embodiments of the present technology.

When adding reference numerals to components in each drawing, it should be noted that the same components are given the same reference numerals as much as possible even if they are shown in different drawings. In addition, when describing various embodiments disclosed in this document, if a specific description of a related known configuration or function is determined to hinder understanding of the embodiments of the present disclosure, the detailed description thereof is omitted. A singular form of a noun corresponding to an item may include one item or a plurality of items unless the relevant context clearly indicates otherwise.

In describing the components of the embodiments of this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

In addition, in the present disclosure, expressions of "more than" or "less than" may be used to determine whether a specific condition is satisfied or fulfilled, but this is only a description for expressing an example and does not exclude descriptions of "greater than or equal to" or "less than or equal to". A condition described as "greater than or equal to" may be replaced with "more than", a condition described as "less than or equal to" may be replaced with "less than", and a condition described as "greater than or equal to and less than" may be replaced with "more than and less than or equal to". In addition, hereinafter, "A" to "B" mean at least one of the elements from A (including A) to B (including B).

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

The method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or temporarily generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by adding one or more other operations.

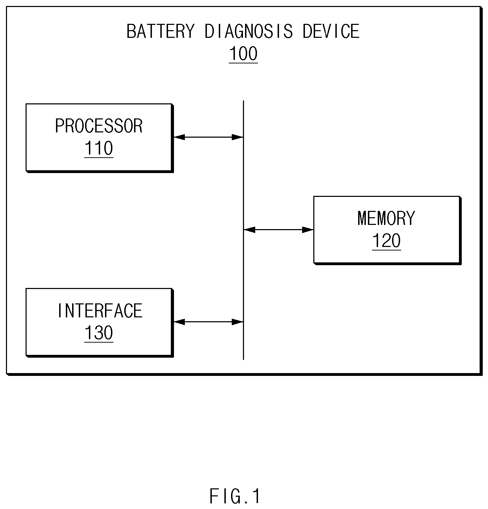

FIG. 1 is a block diagram illustrating the configuration of a battery management device according to an embodiment disclosed in this document. According to an embodiment, a battery management device 100 of FIG. 1 may be included in the battery or may be configured as another device external to the battery. For convenience of description, it will be described on the premise that the battery management device 100 is configured as another device outside the battery.

The battery management device 100 according to an embodiment may include at least one of a processor 110, a memory 120, and an interface 130. The processor 110, the memory 220, and the interface 130 may be electronically and/or operably coupled with each other by an electronic component including a communication bus. Hereinafter, operably coupling pieces of hardware with each other may mean a direct connection and/or an indirect connection between pieces of hardware being established in a wired manner and/or wirelessly, such that a second piece of hardware is controlled by a first piece of hardware among the pieces of hardware. Although pieces of hardware are illustrated in different blocks, embodiments are not limited thereto. Some of the pieces of hardware of FIG. 1 (e.g., at least a portion of the processor 110, memory 120, and communication circuit (not shown)) may be included in a single integrated circuit, such as a system on a chip (SoC). Communication methods between components may include buses, general purpose input and output (GPIO), serial peripheral interface (SPI), mobile industry processor interface (MIPI), etc.

The processor 110 of the battery management device 100 according to an embodiment may include a hardware component for processing data based on one or more instructions. Hardware components for processing data may include, for example, an arithmetic and logic unit (ALU), a floating point unit (FPU), a field programmable gate array (FPGA), a central processing unit (CPU), a micro controller unit (MCU), and/or an application processor (AP). The number of processors 110 may be one or more. For example, the processor 110 may have a multi-core processor architecture having dual cores, quad cores, hexa cores, or octa cores.

The memory 120 of the battery management device 100 according to an embodiment may include hardware components for storing data and/or instructions input and/or output to and from the processor 110. The memory 120 may include, for example, a volatile memory such as a random-access memory (RAM) and/or a non-volatile memory such as a read-only memory (ROM). For example, the volatile memory may include at least one of dynamic RAM (DRAM), static RAM (SRAM), cache RAM, and pseudo SRAM (PSRAM). For example, the non-volatile memory may include at least one of programmable ROM (PROM), erasable PROM (EPROM), electrically erasable PROM (EEPROM), flash memory, a hard disk, a compact disc, a solid state drive (SSD), and an embedded multi-media card (eMMC). The memory 120 may be configured to store a voltage profile representing the voltage relative to the capacity of the battery cell.

The interface 130 of the battery management device 100 according to an embodiment may be configured to generate various battery measurement values from the battery. To this end, the interface 130 may include measuring means such as a voltmeter, ammeter, thermometer, etc., and a communication circuit for establishing a communication link with an external device. The interface 130 may be configured to acquire the voltage profile representing the voltage relative to the capacity of the battery cell.

For example, a voltage profile may represent the voltage relative to the capacity of an identified battery cell while charging or discharging the battery cell. The voltage profile may include a first-order differential voltage profile acquired through differentiation of the voltage profile and/or a second-order differential voltage profile acquired through differentiation of the first-order differential voltage profile.

The battery management device 100 (or the processor 110) according to an embodiment may identify at least one inflection point based on the voltage profile.

For example, the battery management device 100 may acquire the second-order differential voltage profile acquired through second-order differentiation of the voltage profile.

For example, the battery management device 100 may identify at least one inflection point in the second-order differential voltage profile.

For example, at least one inflection point may represent characteristics of at least one of a positive electrode material or a negative electrode material contained within the battery cell. As an example, at least one inflection point may represent characteristics of silicon contained in the negative electrode of the battery cell. As an example, at least one inflection point may represent a point at which the reaction of silicon begins.

The battery management device 100 according to an embodiment may identify the capacity of silicon contained in the battery cell by using at least one inflection point.

In an embodiment, the battery management device 100 may identify the capacity of silicon using a first capacity value of the battery cell corresponding to at least one inflection point and a second capacity value corresponding to an end point of the second-order differential voltage profile.

The battery management device 100 according to an embodiment may control charging of a battery cell based on the capacity of silicon.

In an embodiment, the battery management device 100 may identify a total capacity profile representing the capacity of the battery cell according to the use of the battery cell. For example, the battery management device 100 may identify a silicon capacity profile that represents the capacity of silicon according to the use of the battery cell.

The battery management device 100 according to an embodiment may control charging of the battery cell according to the total capacity profile and the silicon capacity profile.

In an embodiment, the battery management device 100 may identify a total capacity value of the total capacity profile at a designated point in time. In an embodiment, the battery management device 100 may identify a silicon capacity value of the silicon capacity profile at a designated point in time.

The battery management device 100 according to an embodiment may control charging of the battery cell when a ratio of the silicon capacity value to the total capacity value is less than or equal to a designated ratio.

In an embodiment, the battery management device 100 may set a designated voltage of the battery cell. The battery management device 100 may control charging of the battery cell based on the designated voltage.

In an embodiment, when the designated voltage is an upper limit charging voltage, the battery management device 100 may stop charging the battery cell when the voltage of the battery cell corresponds to the upper limit charging voltage. For example, the upper limit charging voltage may represent a maximum voltage for preventing degradation of the battery cell.

In an embodiment, the battery management device 100 may adjust the upper limit charging voltage. For example, the battery management device 100 may lower the upper limit charging voltage to prevent the depth of charging of silicon particles contained in the battery cell from being increased to a predetermined level or more.

In an embodiment, when the designated voltage is a lower limit discharging voltage, the battery management device 100 may charge the battery cell when the voltage of the battery cell corresponds to the lower limit discharging voltage. For example, the lower limit discharging voltage may represent a minimum voltage for preventing degradation of the battery cell.

In an embodiment, the battery management device 100 may adjust the lower limit discharging voltage. For example, the battery management device 100 may increase the lower limit discharging voltage to prevent degradation due to breakage of silicon particles contained in the battery cell. However, it is not limited thereto.

The battery management device 100 according to an embodiment as described above may identify a point in time (e.g., at least one inflection point) at which the reaction of silicon begins by using the second-order differential voltage profile. That is, the battery management device 100 may determine a reaction point in time for each material in the battery cell using the second-order differential voltage profile.

For example, the battery management device 100 may quantify the degree of degradation of silicon based on identifying the point in time when the silicon reaction begins. As an example, the battery management device 100 may quantify the degree of degradation of silicon using a first capacity of silicon identified in a battery cell in a beginning of life (BOL) state and a second capacity of silicon identified in a battery cell in a current state.

For example, when silicon degradation progresses, since the overall degradation of the negative electrode containing silicon is expected, the battery management device 100 may control charging of the battery cell to prevent lithium deposition. For example, the battery management device 100 may slow down the degradation of the battery cell based on controlling the charging of the battery cell by quantifying the degree of degradation of silicon.

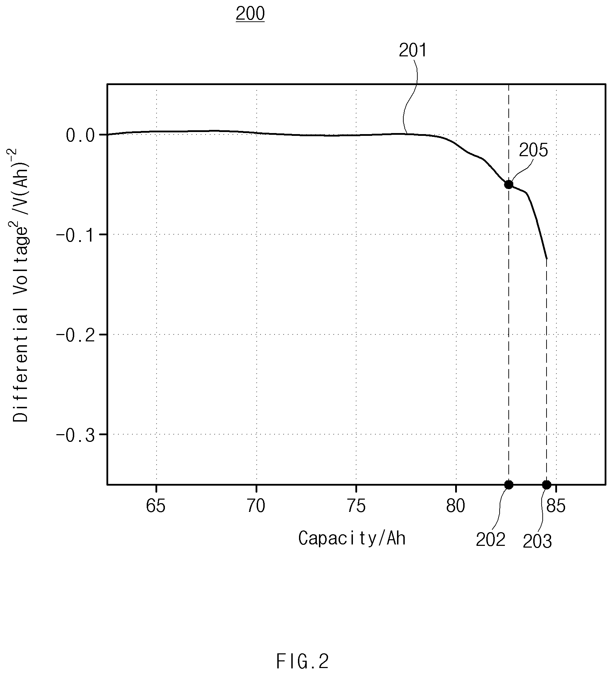

FIG. 2 illustrates an example of a graph representing a voltage profile acquired by a battery management device according to an embodiment disclosed in this document. The battery management device 100 of FIG. 2 may be referenced to the battery management device 100 of FIG. 1.

Referring to FIG. 2, a graph 200 may include a voltage profile 201 representing the voltage of a battery cell relative to the capacity of the battery cell. The voltage profile may include a second-order differential voltage profile. That is, the voltage profile may represent the second-order differential voltage relative to the capacity of the battery cell.

In an embodiment, the battery management device 100 may identify at least one inflection point 205 in the voltage profile 201. Based on identifying at least one inflection point, the battery management device 100 may identify the capacity of silicon using a first capacity value 202 corresponding to the at least one inflection point and a second capacity value 203 corresponding to an end point of the voltage profile.

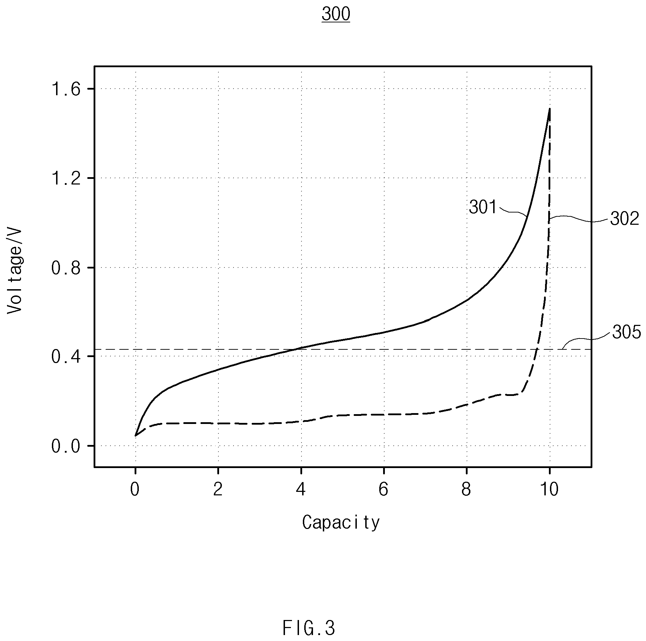

For example, at least one inflection point 205 may be identified after a first negative electrode material (e.g., graphite) contained in the negative electrode is discharged. The at least one inflection point 205 may indicate a point in time at which discharging of a second negative electrode material contained in the negative electrode is initiated. However, it is not limited thereto. Hereinafter, with reference to FIG. 3, reaction characteristics according to the materials contained in the battery cell will be described in more detail.

FIG. 3 illustrates an example of a graph corresponding to a type of an electrode included in a battery cell according to an embodiment disclosed in this document. The battery management device 100 of FIG. 3 may be referenced to the battery management device 100 of FIG. 1.

The battery management device 100 according to an embodiment may acquire a voltage profile based on at least one of a positive electrode or a negative electrode included in the battery cell using an interface. A voltage profile acquired based on at least one of the electrodes included in the battery cell may be referred to as a half voltage profile (e.g., a positive voltage profile and a negative voltage profile) in terms of half battery cell.

Referring to FIG. 3, a graph 300 may include a first negative electrode voltage profile 301 representing a voltage of a first negative electrode material with respect to a capacity of the first negative electrode material (e.g., silicon) contained in the battery cell. The graph 300 may include a second negative electrode voltage profile 302 representing the voltage of a second negative electrode material relative to the capacity of the second negative electrode material (e.g., graphite) contained in the battery cell.

Referring to the first negative electrode voltage profile 301, it can be seen that the capacity of the first negative electrode material is expressed after a specific voltage (e.g., approximately 0.4 V). Referring to the second negative electrode voltage profile 302, it can be seen that the second negative electrode material starts discharging at a first voltage (e.g., approximately 0.1 V), and the capacity of the second negative electrode material is expressed relatively more than that of the first negative electrode material at a second voltage or less (e.g., approximately 0.3 V).

The battery management device 100 according to an embodiment described above may identify a point in time (e.g., at least one inflection point 205 of FIG. 2) when the capacity of a specific material is expressed, based on the characteristics by which the capacity of the material is expressed, depending on the type of material. The battery management device 100 may identify the degree of degradation for each material contained in the battery cell based on identifying the point in time when the capacity of a specific material (e.g., silicon) is expressed.

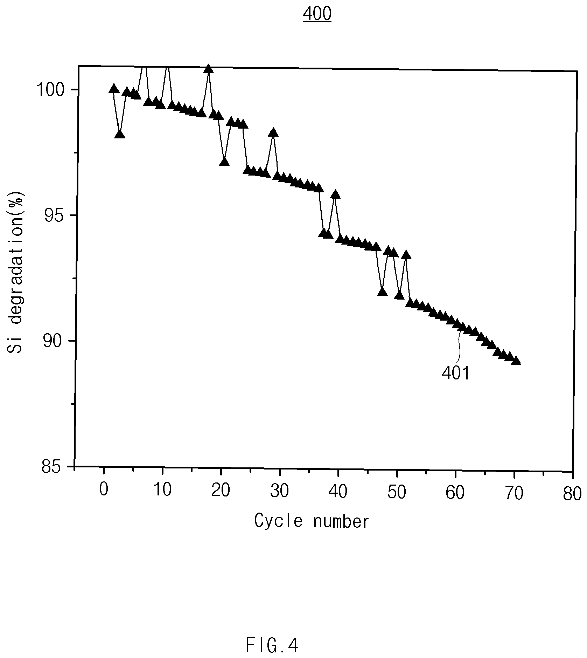

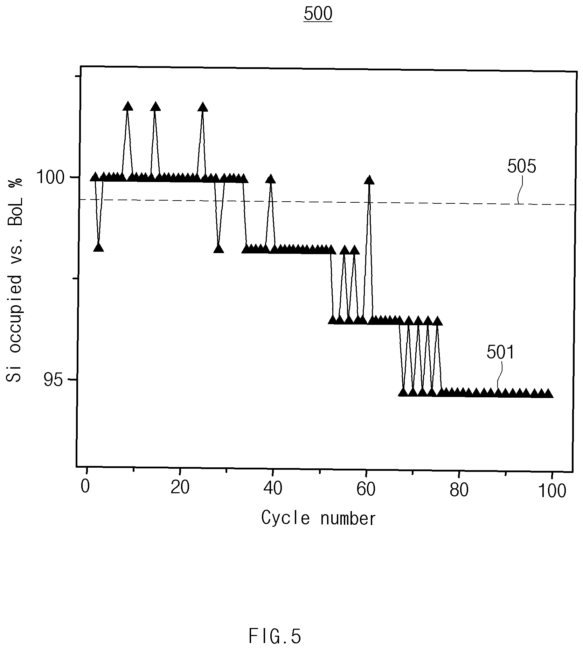

FIG. 4 illustrates an example of a graph showing the degree of degradation of the capacity of silicon according to an embodiment disclosed in this document. FIG. 5 illustrates an example of a graph showing a ratio of the capacity of silicon according to an embodiment disclosed in this document. The battery management device 100 of FIGS. 4 and 5 may be referenced to the battery management device 100 of FIG. 1.

Referring to FIG. 4, a graph 400 may include a silicon capacity profile 401 indicating the capacity (or the degree of degradation) of silicon according to the use of the battery cell.

Referring to the graph 400, the battery management device 100 according to an embodiment may identify the capacity of silicon within the battery cell over time. The battery management device 100 may identify the capacity of silicon by identifying at least one inflection point 205 using the voltage profile 201 of FIG. 2.

Referring to FIG. 5, a graph 500 may include a ratio graph 501 representing a ratio of the capacity of silicon of a battery cell to the total capacity of the battery cell.

Referring to the graph 500, the battery management device 100 according to an embodiment may identify a total capacity profile relative to the total capacity of a battery cell. The battery management device 100 may identify a ratio of a silicon capacity value of a silicon capacity profile to a total capacity value of a total capacity profile by using the total capacity profile and the silicon capacity profile at a designated point in time.

As an example, the ratio of the silicon capacity value of the silicon capacity profile to the total capacity value of the total capacity profile identified in the battery cell in the beginning of life (BOL) state may be referred to as a designated ratio 505 (e.g., 100%).

The battery management device 100 according to an embodiment may control charging of the battery cell when the ratio of the silicon capacity value to the total capacity value is less than or equal to the designated ratio 505 at a designated point in time. When the ratio of the silicon capacity value to the total capacity value is less than or equal to the designated ratio 505, it may indicate a state in which silicon is not expressed.

For example, the battery management device 100 may control the charging of the battery cell by changing the upper limit charging voltage or lower limit discharging voltage of the battery cell.

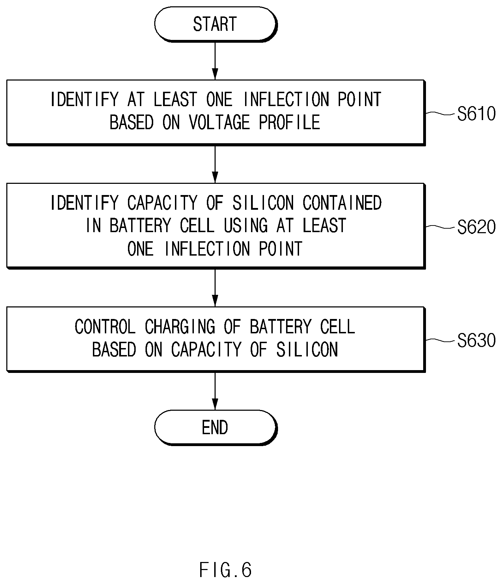

FIG. 6 illustrates an example of an exemplary flowchart illustrating an operation of a battery management device according to an embodiment disclosed in this document. Hereinafter, it is assumed that the battery management device 100 of FIG. 1 performs the process of FIG. 6. In addition, it may be understood that the operation described as being performed by the device is controlled by the processor 110 of the battery management device 100. Each of the operations of FIG. 6 may be performed sequentially, but is not necessarily performed sequentially. For example, the order of each of the operations may be changed, and at least two operations may be performed in parallel.

In operation S610, the battery management device according to an embodiment may identify at least one inflection point based on the voltage profile. For example, the battery management device may acquire a voltage profile representing the capacity of the battery cell relative to the voltage of the battery cell. For example, the voltage profile may include a second-order differential voltage profile through second-order differentiation.

For example, the second-order differential voltage profile may represent the characteristics of each material contained within the battery cell.

For example, at least one inflection point may represent a point based on the characteristics of each of the materials contained within the battery cell. As an example, at least one inflection point may be used to identify the capacity of silicon in the battery cell.

In operation S620, the battery management device according to an embodiment may identify the capacity of silicon contained in the battery cell using at least one inflection point. For example, the capacity of silicon may be identified using a first capacity corresponding to at least one inflection point and a second capacity representing the maximum capacity of the battery cell at the current point in time. However, it is not limited thereto.

In operation S630, the battery management device according to an embodiment may control charging (or discharging) of the battery cell based on the capacity of silicon.

For example, the battery management device may determine whether to control charging of the battery cell based on a first ratio between the capacity of silicon and the total capacity of the battery cell.

For example, the battery management device may lower the upper limit charging voltage of the battery cell when the first ratio is less than or equal to a designated ratio. For example, the battery management device may increase the lower limit discharging voltage of the battery cell when the first ratio is less than or equal to the designated ratio.

For example, the battery management device may be configured to set the voltage of the battery cell to be maintained within a designated range by changing the upper limit charge voltage or the lower limit charge voltage. For example, by setting the battery cell voltage to be maintained within the designated range, the battery management device may control the degradation of a specific material (e.g., silicon) of the battery cell.

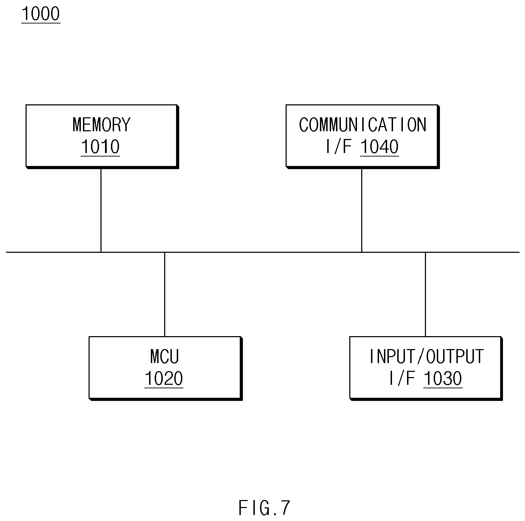

FIG. 7 illustrates a computing system executing a battery management method according to an embodiment disclosed in this document.

Referring to FIG. 7, a computing system 1100 according to an embodiment disclosed in this document may include an MCU 1010, a memory 1020, an input/output I/F 1030, and a communication I/F 1040.

The MCU 1010 may be a processor that executes various programs stored in the memory 1020 (e.g., an SOH calculation program, a cell balancing target determination program, etc.), processes various data including the state of charge (SOC), state of health (SOH), etc. of a plurality of battery cells through these programs, and performs the functions of the battery management device 100 described with reference to FIGS. 1 to 6. The MCU 1010 may be, but is not limited to, a BMS, a separate PC, or the cloud.

The memory 1020 may store various programs related to calculating the SOH of battery cells and determining the target for cell balancing. Furthermore, the memory 1020 may store various data, such as SOC data and SOH data for each battery cell.

A plurality of such memories 1020 may be provided as needed. The memory 1020 may be a volatile memory or a nonvolatile memory. The memory 1020 used as the volatile memory may be RAM, DRAM, SRAM, etc. The memory 1020 used as the nonvolatile memory may be ROM, PROM, EAROM, EPROM, EEPROM, flash memory, etc. The examples of the memories 1020 listed above are only examples and are not limited to these examples.

The input/output I/F 1030 may provide an interface that allows data to be transmitted and received by connecting an input device (not shown) such as a keyboard, mouse, or touch panel and an output device (not shown) such as a display with the MCU 1010.

The communication I/F 1040 is a configuration that can transmit and receive various data with the server, and may be various devices that can support wired or wireless communication. For example, a program or various data for calculating the SOH of a battery cell or determining a balancing target may be transmitted to and received from a separately provided external server through the communication I/F 1040.

In this way, the battery management method according to an embodiment disclosed in this document may be recorded in the memory 1020 and executed by the MCU 1010.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above description is merely an example of the technical idea disclosed in this document, and those skilled in the art to which the embodiments disclosed in this document pertain may make various modifications and variations without departing from the essential characteristics of the embodiments disclosed in this document. Accordingly, the embodiments disclosed in this document are intended to describe rather than limit the technical ideas of the embodiments disclosed in this document, and the scope of the technical ideas disclosed in this document is not limited by these embodiments. The scope of protection of the technical ideas disclosed in this document should be interpreted by the scope of the claims below, and all technical ideas within the equivalent scope should be interpreted as being included in the scope of rights of this document.

## Claims

1. A battery management device comprising:
an interface configured to acquire a voltage profile representing a voltage relative to a capacity of a battery cell; and
at least one processor,
wherein the at least one processor is configured to:
identify at least one inflection point based on the voltage profile;
identify a capacity of silicon contained in the battery cell using the at least one inflection point; and
control charging or discharging of the battery cell based on the capacity of silicon.

2. The battery management device of claim 1, wherein the at least one processor is configured to:
acquire a second-order differential voltage profile acquired through second differentiation of the voltage profile; and
identify the at least one inflection point in the second-order differential voltage profile.

3. The battery management device of claim 2, wherein the at least one processor is configured to identify the capacity of silicon using a first capacity value of the battery cell corresponding to the at least one inflection point and a second capacity value corresponding to an end point of the second-order differential voltage profile.

4. The battery management device of claim 1, wherein the at least one processor is configured to:
identify a total capacity profile representing the capacity of the battery cell according to the use of the battery cell;
identify a silicon capacity profile representing the capacity of silicon according to the use of the battery cell; and
control charging or discharging of the battery cell according to the total capacity profile and the silicon capacity profile.

5. The battery management device of claim 4, wherein the at least one processor is configured to:
identify a total capacity value of the total capacity profile at a designated point in time;
identify the silicon capacity value of the silicon capacity profile at the designated point in time; and
control charging or discharging of the battery cell when a ratio of the silicon capacity value to the total capacity value is less than or equal to a designated ratio.

6. The battery management device of claim 1, wherein the at least one processor is configured to:
set a designated voltage of the battery cell; and
control charging or discharging of the battery cell based on the designated voltage.

7. The battery management device of claim 6, wherein the at least one processor is configured to reduce an upper limit charging voltage when the designated voltage is the upper limit charging voltage.

8. The battery management device of claim 6, wherein the at least one processor is configured to increase a lower limit discharging voltage when the designated voltage is the lower limit discharging voltage.

9. A battery management method comprising:
an operation of identifying at least one inflection point based on a voltage profile representing a voltage relative to a capacity of a battery cell;
an operation of identifying a capacity of silicon contained in the battery cell using the at least one inflection point; and
an operation of controlling charging or discharging of the battery cell based on the capacity of silicon.

10. The battery management method of claim 9, wherein the operation of identifying the at least one inflection point includes:
an operation of acquiring a second-order differential voltage profile acquired through second differentiation of the voltage profile; and
an operation of identifying the at least one inflection point in the second-order differential voltage profile.

11. The battery management method of claim 10, wherein the operation of identifying the capacity of silicon includes an operation of identifying the capacity of silicon using a first capacity value of the battery cell corresponding to the at least one inflection point and a second capacity value corresponding to an end point of the second-order differential voltage profile.

12. The battery management method of claim 9, wherein the operation of controlling the charging of the battery cell includes:
an operation of identifying a total capacity profile representing the capacity of the battery cell according to the use of the battery cell;
an operation of identifying a silicon capacity profile representing the capacity of silicon according to the use of the battery cell; and
an operation of controlling charging or discharging of the battery cell according to the total capacity profile and the silicon capacity profile.

13. The battery management method of claim 12, wherein the operation of controlling the charging of the battery cell includes:
an operation of identifying a total capacity value of the total capacity profile at a designated point in time;
an operation of identifying the silicon capacity value of the silicon capacity profile at the designated point in time; and
an operation of controlling charging or discharging of the battery cell when a ratio of the silicon capacity value to the total capacity value is less than or equal to a designated ratio.

14. The battery management method of claim 9, wherein the operation of controlling the charging of the battery cell includes:
an operation of setting a designated voltage of the battery cell; and
an operation of controlling charging or discharging of the battery cell based on the designated voltage.

15. The battery management method of claim 14, wherein the operation of controlling the charging of the battery cell further includes an operation of reducing an upper limit charging voltage when the designated voltage is the upper limit charging voltage.
